# EUROPEAN PATENT APPLICATION

(11) **EP 4 057 335 A1**
(43) Date of publication of application: **14.09.2022**
(21) Application number: 21161835.0
(22) Date of filing: 10.03.2021
(51) Int. Cl.: H01L 23/31, H01L 25/07, H01L 23/29

(54) **SEMICONDUCTOR PACKAGE AND MANUFACTURING METHOD**

(71) Applicant: Hitachi Energy Switzerland AG, 5400 Baden (CH)
(72) Inventor: BEYER, Harald, 5600 Lenzburg (CH); GUILLON, David, 8857 Vorderthal (CH)
(74) Representative: Epping - Hermann - Fischer

(57) **Abstract**

In at least one embodiment, the semiconductor package (1) comprises:
- a package body (4),
- at least one semiconductor chip (2) arranged in the package body (4), and
- at least two electric terminals (3) by means of which the at least one semiconductor chip (2) is electrically connected, the at least two electric terminals (3) protrude from the package body (4),
wherein
- the package body (4) comprises a first body compound (41) and a second body compound (42), the first body compound (41) has a lower comparative tracking index, CTI, than the second body compound (42), and
- the CTI of the second body compound (42) is at least 100 larger than the CTI of the first body compound (41).

## Description

A semiconductor package is provided. A method for manufacturing such a semiconductor package is also provided.

Document WO 2013/111276 A1 refers to an electric power semiconductor device for a motor vehicle.

Document WO 2017/138402 A1 discloses a semiconductor device that has a second resin layer having a small coefficient of thermal expansion that covers at least an upper surface of a first resin layer.

Document US 2011/0049701 A1 describes a semiconductor device with heat dissipation plates and a resin encapsulating element.

Embodiments of the disclosure relate to a power semiconductor device that has can be manufactured cost-efficiently.

Embodiments of the disclosure relate to a semiconductor package and by a method as defined in the independent patent claims. Exemplary further developments constitute the subject-matter of the dependent claims.

For example, the semiconductor package houses at least one power semiconductor chip and comprises a package body with a first body compound and a second body compound. The second body compound may have an increased comparative tracking index and is applied in places where creeping distance is critical. Hence, by using the first body compound a cost-efficient molding process by using a standard mold compound can be enabled while using the second body compound enables a compact design because electric creepage can sufficiently be suppressed, and the second body compound can efficiently be provided by molding, too. For example, the second body compound is a more expensive material used only where it is needed and, for example, configured for a special purpose like increasing creeping distance.

In at least one embodiment, the semiconductor package comprises:
- a package body,
- at least one semiconductor chip arranged in the package body, and
- at least two electric terminals by means of which the at least one semiconductor chip is electrically connected, the at least two electric terminals protrude from the package body,
wherein
- the package body comprises a first body compound and a second body compound, the first body compound has a lower comparative tracking index, CTI, than the second body compound, and
- the CTI of the second body compound is at least 100 larger than the CTI of the first body compound.

Transfer molding is an efficient technology for the encapsulation of, for example, small integrated circuits of low voltage applications, where chips are joined to leadframes and encapsulated in a small package body of a few cm side length. Otherwise, in the field of power electronics large power semiconductor modules are assembled, that are built-up by substrates with chips, that are soldered to baseplates, for example. For the encapsulation, a frame may be mounted to the baseplate, and the structure is filled with dielectric gel or potting resin. Transfer molding technology may be for the assembly of intelligent power semiconductor modules, basing on a common setup of power and control devices, that are used for low voltage applications like consumer electronics, or for small discrete power packages, used for power devices in low voltage classes.

However, there is a trend towards the realization of larger power semiconductor modules for higher voltages and currents by transfer molding. Such leadframe-based molded power semiconductor packages are differing from IC packages by several features, like, for example:
- power semiconductor packages may have large package bodies of up to 80 mm side length and more than 10 mm body thickness, and thus may require increased mechanical stability,
- power semiconductor packages may comprise power terminals made of thick copper,
- power semiconductor packages comprise an encapsulation of isolating substrates and heatsinks having backsides typically exposed from the package body,
- power semiconductor packages may be configured for high electric current and voltage, for example, higher than 1 kV,
- power semiconductor packages may have a leak-tight mounting to a cooler for liquid cooling, and/or
- power semiconductor packages may be used in harsh environmental conditions, for example, in automotive applications.

Based on such features, but also with respect to customer requirements, a well suited mold compound should be chosen to fulfil all these different requirements. Package bodies with a homogenous transfer molded body consisting of one mold compound may fulfil these aspects, however, requiring comparably high manufacturing costs, or a compromise between different requirements need to be found.

Exemplarily the large size of new transfer molded power semiconductor packages described herein may result in different local requirements for the optimum behavior of the encapsulation material used for the package body. So, some regions of the package body, like the vicinity of the semiconductor chips or of the electric terminals, are more critical with respect to specific requirements for the encapsulation material than other package body parts. Possible requirements are, for example, thermo-mechanical behavior, adhesion of a mold compound, dielectric strength, or protection against humidity and hazardous gases. It is difficult to find only one mold compound which fulfils all mentioned requirements in an optimum way. So, when using only one body compound, the choice of the material for the package body is always a compromise between different requirements.

When considering a possible use of a molded power semiconductor package for high voltage applications, a sufficient creep distance on a surface of the molded package body between power module parts, especially between electric terminals having different electrical potential need to be considered, or also between electric terminals and a cooling body or a baseplate being electrically on ground. The creep distance depending on the voltage is needed to prevent creepage current between power electric terminals of different potential. On one hand, a sufficient creep distance can be provided by an elongation of the surface path between electric terminals, for example, by ribs or recessed portions. On the other hand, the choice of the material with respect to the comparative tracking index, CTI for short, provides a sufficient creep distance in combination with an effective geometric surface distance. So, if only a small distance between parts of different electric potential is available, a material with a high CTI value may enable a sufficient creep distance, optionally with a corresponding rib structure.

Nevertheless, a corresponding semiconductor package may have a large molded package body, but this package body is typically smaller than an alternative gel filled power module. Hence, smaller distances between electric terminals should be considered. Consequently, a body compound should be chosen providing a large CTI value at least in the region of the power electric terminals. Otherwise, it should be considered that a mold compound having a high CTI value may not have optimum thermo-mechanical or other properties, which are important for other package parts, or may be comparably expensive.

To improve the molded power semiconductor package having a large package body focusing on the creep distance, the use of two or more body compound, like mold compounds, with different material properties related to different CTI values for the encapsulation should be realized. Here, a body compound having a higher CTI value compared with that used for other package body parts is chosen in regions of the package body where the creepage distance is a critical feature, as it is, for example, in the region of the power and auxiliary electric terminals themselves, but also between power electric terminals and an optional cooler. The realization of the package body of a corresponding power semiconductor package can be done by different setups related to allocation of body compounds, that is, for example, of mold compounds.

The choice of the body compound to be used for other parts of the package body can be done according to the fulfilment of requirements, which are important in the respective package body parts, like thermos-mechanical behavior, adhesion of the respective body compound, dielectric strength, or protection against humidity and hazardous gases. For the latter requirements, it may not be important to use a specific body compound having a high CTI value.

The manufacturing of a molded power semiconductor package having a package body made from different body compounds can be done, for example, in a sequential molding process of two or more process steps using different mold tools according to the shape of the local mold bodies.

The preparation of a large molded power semiconductor package, where the package body is composed of local parts, prepared by different body compounds like mold compounds, for example, having different CTI values, may have several advantages despite of higher manufacturing costs caused by the two or more process steps in, for example, a transfer molding process. Basing on the local requirements, the locally optimum body compounds can be chosen:
- Improved creep behavior between electric terminals or between electric terminals and an optional cooler or also between power terminals and auxiliary terminals, which is related to CTI values of the respective compounds.
- Improved reliability with respect to humidity and hazardous gases, for example, by reduced penetration of gases and/or humidity, for example, at corrosion sensitive package parts.
- Improved thermo-mechanical reliability by improved adhesion or by reinforcement of body compounds to electric terminals and/or to a substrate and/or to a baseplate and or to different leadframe parts, for example, if the semiconductor package is a leadframe based package.
- Improved local stability against high electrical field strengths.

Exemplarily, to provide a sufficient creep distance in critical regions, a body compound having a high CTI value can be chosen, whereas other important material properties can be considered for other parts of the package body. If sufficient creepage distances are available at low geometric distances, the local use of a body compound having a high CTI value may support miniaturization of the semiconductor package due to possible smaller geometric distances between terminals of different electrical potential.

Beside these technical features and the higher manufacturing costs, a reduction of the material costs may be possible. If the package body of the semiconductor package comprises only one homogeneous material, the complete mold body needs to fulfil all requirements despite of only local demand. If different body compounds are used, mold compounds of specific properties need only to be used on positions where they are really necessary. For parts of the package body underlying lower requirements, a comparably cheap body compound with inferior properties may be used.

According to at least one embodiment, the first body compound and/or the second body compound comprises or is made of a thermoset material or a thermoplastic material. A thermoset material may be made on the basis of a resin, like an epoxy resin. A thermoplastic material may comprise one or more materials of the group of polyetherimide (PEI), polyethersulfone (PES), polyphenylene-sulfide (PPS), or polyamideimide (PAI), or other thermoplastic materials like Polybutylene terephthalate (PBT) or Polyethylene terephthalate (PET). Thermoplastic materials melt by application of pressure and heat during molding or lamination and reversibly harden upon cooling and pressure release. The first body compound and/or the second body compound may comprise or may be made of a polymer material, like a filled or unfilled mold material, a filled or unfilled thermoplastic material, a filled or unfilled thermoset material, a filled or unfilled laminate, a fiber-reinforced laminate, a fiber-reinforced polymer laminate, and a fiber-reinforced polymer laminate with filler particles.

According to at least one embodiment, the first body compound and/or the second body compound comprise at least one basic material for providing different CTI values selected from the following group: phenolic resin, brominated resin, amino resin, epoxy novolac resin. A novolac resin is a low molecular weight polymer derived from phenols and formaldehyde, for example, with formaldehyde-to-phenol-ratio of less than one.

According to at least one embodiment, the second body component having the higher CTI value contains any kind of oxides like aluminum oxide, iron oxide, magnesium oxide or any other kind of oxides, and alternatively or additionally a bromine and/or asbestos, suited for an enhancement of the CTI value, as a second filler. The second filler may also be referred to as additive.

According to at least one embodiment, the package body comprises at least one third body compound different from the first body compound and the second body compound. For example, the at least one third body compound has at least one of a lower coefficient of thermal expansion, a higher flexural modulus, and a lower thermal resistance, compared with the first body compound and/or the second body compound; however, depending on the specific requirements of the respective application and of its position within the semiconductor package, the at least one third body compound may alternatively have higher coefficient of thermal expansion and/or a lower flexural modulus. The at least one third body compound may be a molded, potted or casted body, too, like the first body compound and/or the second body compound.

A method for manufacturing the semiconductor package is additionally provided. By means of the method, a semiconductor package may be produced as indicated in connection with at least one of the above-stated embodiments. Features of the semiconductor package are therefore also disclosed for the method, and vice versa.

In at least one embodiment, the method is for manufacturing a semiconductor package and comprises the following steps, for example, in the stated order:
A) providing the at least one semiconductor chip and the at least two electric terminals, the at least one semiconductor chip is electrically connected by means of the at least two electric terminals,
B) applying the first body compound around the at least one semiconductor chip so that the at least two electric terminals protrude from the first body compound or are located completely or partially out of the first body compound, and
C) applying the second body compound on the first body compound at least at places where the at least two electric terminals emerge from the finished package body that comprises the first body compound and the second body compound and/or at least at places which are critical concerning electric creepage behavior.

The first compound body may be applied by means of molding. Here and in the following, molding may include techniques like transfer molding, compression molding, potting or casting.

The first compound body may be applied directly on the at least one semiconductor chip and the at least two electric terminals. However, there can also be another part of the semiconductor package between the at least one semiconductor chip and the at least two electric terminals on the one hand and the first compound body on the other hand, so that there is no direct contact between the first compound body and the at least one semiconductor chip and/or no direct contact between the first compound body and the at least two electric terminals. For example, the electric terminals are located only in the second body compound and are distant from the first body compound, otherwise uncritical terminals can be embedded only in the first body compound.

The second compound body may also be applied by means of molding. Alternatively, the second compound body may be created from the already applied first compound body, for example, by means of a treatment that changes the chemical set-up of the first compound body. Such a treatment may be a plasma treatment, exposure to a gas or a liquid as a reacting agent, heat treatment and/or radiation treatment, like exposure to ultraviolet radiation. As a further alternative, the second body compound may also be a coating applied, for example, onto the first body compound.

According to at least one embodiment, the second compound body is surface-treated after step C) to further increase its CTI. In this, case the second compound body may be applied by molding, and then is surface-treated to improve creepage behavior. Such a surface treatment may be a plasma treatment, for example, with ozone, may be exposure to a gas or a liquid as a reacting agent, may be a heat treatment and/or may be a radiation treatment, like exposure to ultraviolet radiation.

A semiconductor package and a method described herein are explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:
- Figure 1: is a schematic sectional view of an exemplary embodiment of a semiconductor package described herein,
- Figures 2: and 3 are schematic top views of exemplary embodiments of semiconductor packages described herein,
- Figures 4: to 7 are schematic sectional views of exemplary embodiments of semiconductor packages described herein,
- Figures 8: and 9 are schematic top views of exemplary embodiments of semiconductor packages described herein,
- Figure 10: is a schematic block diagram of an exemplary embodiment of a method to manufacture semiconductor packages described herein, and
- Figures 11: and 12 are schematic sectional views of exemplary embodiments of semiconductor packages described herein.

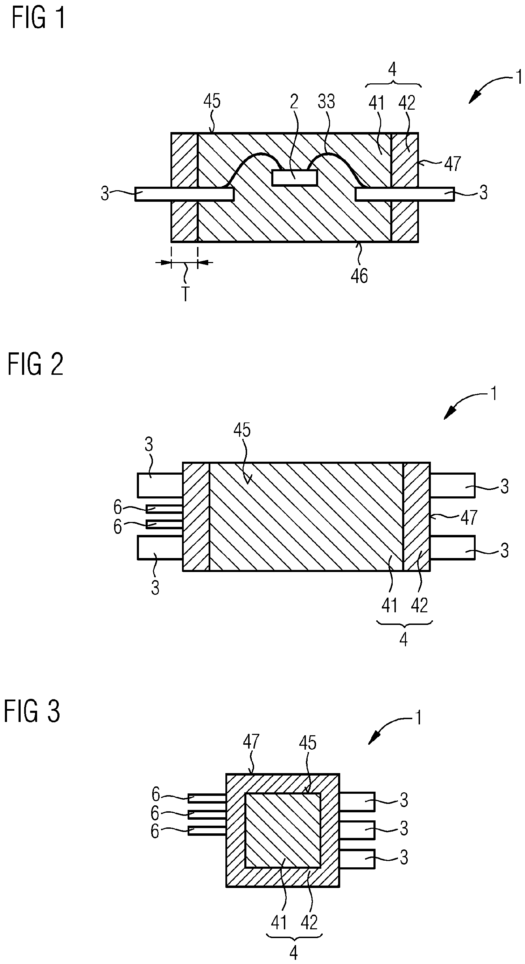

Figure 1 illustrates an exemplary embodiment of a semiconductor package 1. The semiconductor package 1 comprises an electrically insulating package body 4. At least one semiconductor chip 2 is embedded in the package body 4. The least one semiconductor chip 2 is electrically connected by means of electric terminals 3. Optionally, the at least one semiconductor chip 2 is electrically connected to the terminals 3 by means of electric connection means 33 which are, for example, bond wires. For example, the semiconductor package 1 is a leadframe-based package.

The package body 4 is composed of a first body compound 41 and of a second body compound 42. Both body compounds 41, 42 may be mold compounds. The first body compound 41 may be in direct contact with the at least one semiconductor chip 2 and may embed the electric connection means 33. The electric terminals 3 may also be in direct contact with the first body compound 41, but protrude from the first body compound 41. For example, the electric terminals 3 protrude from the first body compound 41 on two opposite sides.

The second body compound 42 may be distant from the at least one semiconductor chip 2 and is applied, for example, directly on the first body compound 41. Thus, lateral sides 47 of the package body 4 may completely be formed by the second body compound 42. A top side 45 and a bottom side 46 of the package body 4 may be formed of both the first body compound 41 and the second body compound 42 and may be connected by the lateral sides 47. The top side 45 and the bottom side 46 are connected by the lateral sides 47 and are main sides of the package body 4.

The first body compound 41 has a lower comparative tracking index, CTI, than the second body compound. For example, the CTI of the second body compound 42 is at least 50 or at least 100 or at least 150 or at least 200 larger than the CTI of the first body compound 41. Alternatively, the materials may be differentiated by isolation classes: material group I: 600 ≤ CTI; material group II: 400 ≤ CTI < 600; material group IIIa: 175 ≤ CTI < 400; material group IIIb: 100 ≤ CTI < 175.

A testing method of the CTI is specified in IEC standard 60112. To measure the tracking, 50 drops of 0.1% ammonium chloride solution are dropped on the respective material, and the voltage measured for a 3 mm thickness is considered representative of the material performance. Instead, the term PTI, Proof Tracking Index, may be used: this term means a voltage at which during testing on five samples the samples pass the test with no failures.

It is possible that the first body compound 41 and the second body compound 42 are of resins, for example, of thermosetting resins. The first body compound 41 and the second body compound 42 may be of the same material as a base material, and the difference in CTI is due to an additive or a filler in the second body compound 42, for example; it is possible, that different types of fillers or additives are combined with each other. Otherwise, the first body compound 41 and the second body compound 42 may be formed from different base materials so that the different CTIs may result at least in part from the selected base material. If there is at least one filler, the base material may be regarded as a matrix material for the filler, if the filler is provided as particles, for example. As another constituent, the first body compound 41 and/or the second body compound may have silicon oxide and or a fiber reinforcement, for example, with a weight proportion between 70% and 90%.

For example, the first body compound 41 is an epoxy material based on phenolic resin. The second body compound 42 may be a bisphenol A type epoxy resin. CTI values of exemplary mold compounds that may be used for the first body compound 41 and the second body compound 42, respectively, are as follows:
- phenolic molding compounds, for example, for voltages up to 175 V,
- phenolic molding compounds with surface treatment, for example, for voltages above 175 V and up to 275 V,
- amino molding compounds, for example, for voltages above 175 V and up to 350 V,
- amino molding compounds with asbestos filler, for example, for voltages above 600 V.

Exemplary ingredients or fillers used in resin materials like potting resins, but also mold compounds, for the first body compound 41 and the second body compound 42 are oxides like aluminum oxide, aluminum hydroxide, iron oxide or magnesium oxide, or other substances like asbestos.

For example, the second body compound 42 is a phenolic molding compound or an amino molding compound or an ethylene compound or a terephthalate compound and comprises at least one of a metal oxide filler and an asbestos filler. For example, the first body compound 41 is an epoxy resin.

Optionally, the package body 4 is of cuboid or nearly cuboid shape or of prismatic or nearly prismatic shape. Hence, the top side 45 and the bottom side 46 may be in parallel with each other and may be the largest faces of the package body 4. Seen in top view, the top side 45 and the bottom side 46 may be of square or rectangular shape.

It is possible that the package body 4 is comparably large. For example, a footprint of the package body is at least 3 cm x 3 cm or at least 5 cm x 5 cm or at least 6 cm x 6 cm. Alternatively or additionally, the footprint of the package body is at most 0.2 m x 0.2 m or at most 0.2 m x 0.2 m or at most 9 cm x 9 cm. The footprint may correspond to a size of the top side 45 and of the bottom side 46.

For example, a thickness of the package body 4, in a direction perpendicular to the top side 45 and/or the bottom side 46, is at least 2 mm or at least 5 mm or at least 7 mm.

Alternatively or additionally, said thickness is at most 0.1 m or at most 3 cm or at most 10 mm.

A thickness T of the second body compound 42, in the case of Figure 1 in a direction parallel with the top side 45, is, for example, at least 0.1 mm or at least 1 mm or at least 2 mm or at least 3 mm. Alternatively or additionally, said thickness T is at most 10 cm or at most 3 cm or at most 1 cm or at most 5 mm. For example, said thickness T amounts to at least 2% or to at least 5% and/or to at most 25% or to at most 10% or to at most 6% of an overall length of the package body 4, seen along the direction at which the thickness T is measured.

For example, a volume proportion of the second body compound 42 on the overall package body 4 is at least 2% or at least 4% or at least 6%. Alternatively or additionally, said volume proportion is at most 50% or is at most 25% or at most 10% or at most 5%. Hence, the volume proportion of the second body compound 42 may be comparably small. For example, resistivity against diffusion of gases into the package body 4 or mechanical strength of the package body 4 mostly relies on the first body component 41, while the second body compound 42 is for adjusting creepage behavior at the lateral sides 47.

Accordingly, the second body compound 42 may form at least places of a surface of the package body 4 where the at least two electric terminals 3 emerge from the package body 4, wherein the first body compound 41 as well as the second body compound 42 may be mold compounds.

According to at least one embodiment, the at least one semiconductor package 4 is a power semiconductor device. This means, for example, that the semiconductor package 4 and/or the at least one semiconductor chips 2 is configured for high currents and/or voltages. For example, the semiconductor package 4 and/or the at least one semiconductor chips 2 is configured to handle a maximum current of at least 1 A or of at least 10 A or of at least 100 A or of at least 500 A. Alternatively or additionally, the semiconductor package 4 and/or the at least one semiconductor chips 2 is configured for voltages of at least 0.5 kV or of at least 1.2 kV or of at least 2 kV.

According to at least one embodiment, the at least one semiconductor chips 2 is a power semiconductor chip and is selected, for example, from the following group: a metal-oxide-semiconductor field-effect transistor (MOSFET), a metal-insulator-semiconductor field-effect transistor (MISFET), an insulated-gate bipolar transistor (IGBT), a bipolar junction transistor (BJT), a thyristor, a gate turn-off thyristor (GTO), a gate commutated thyristor (GCT), a junction gate field-effect transistor (JFET), and a diode. If there is a plurality of the semiconductor chips 2, then all the semiconductor chips 2 can be of the same type, or there are different types of semiconductor chips 2, for example, diodes and IGBTs. It is also possible that the term 'semiconductor chip' does not only include individual, diced chips, but also equivalents, like wafers that comprise a plurality of structures provided in individual chips, for example, and may also include further discrete devices or small packaged chips, for example, used for control purposes.

Hence, the semiconductor package 4 is, for example, a power semiconductor module that is, for example, a power module to convert direct current from a battery to alternating current for an electric motor, for example, in vehicles like hybrid vehicles or plug-in electric vehicles or also in railways, like commuter trains.

In Figure 2, another exemplary embodiment of the semiconductor package 1 is illustrated in a top view. In this case, the second body compound 42 is applied on two opposite lateral sides 47 of the package body 4. The lateral sides 47 may also be referred to as front sides, like in all other exemplarily embodiments. The second body compound 42 may be applied with a constant thickness on the first body compound 41. Hence, the top side 45 is predominantly free of the second body compound 42, despite the second body compound 42 on the two opposite lateral sides 47.

Further, in Figure 2 it is illustrated that there are more than two of the electric terminals 3. As an option, there can be electric auxiliary terminals 6, for example, for signal or control lines for the at least one semiconductor chip, not shown in Figure 2. Compared with the electric terminals 3, the auxiliary terminals 6 may be narrower and also thinner. For example, the electric terminals 3 as well as the auxiliary terminals 6 may be of copper or a copper alloy. Such auxiliary terminals 6 may also be present in all other exemplary embodiments. As shown in Figure 2, the second body compound 42 may also be present between the auxiliary terminals 6 and/or between at least one of the electric terminals 3 and at least one of the auxiliary terminals 6; the same applies to all other exemplary embodiments.

Otherwise, the same as to Figure 1 may also apply to Figure 2, and vice versa.

In the embodiment of Figure 3, the second body compound 42 is applied all around the first body compound 41, for example, with a constant thickness, that is, for example, on all lateral sides 47 of package body 4. Again, the top side 45 may predominantly be free of the second body compound 42.

As a further option, in Figure 3 it is shown that all the electric terminals 3 are located on one lateral side 47, and all the auxiliary terminals 6 are located at another, for example, opposite lateral side 47, contrary to what is shown in Figure 2. The same may apply to all other exemplary embodiments.

Otherwise, the same as to Figure 1 may also apply to Figure 3, and vice versa.

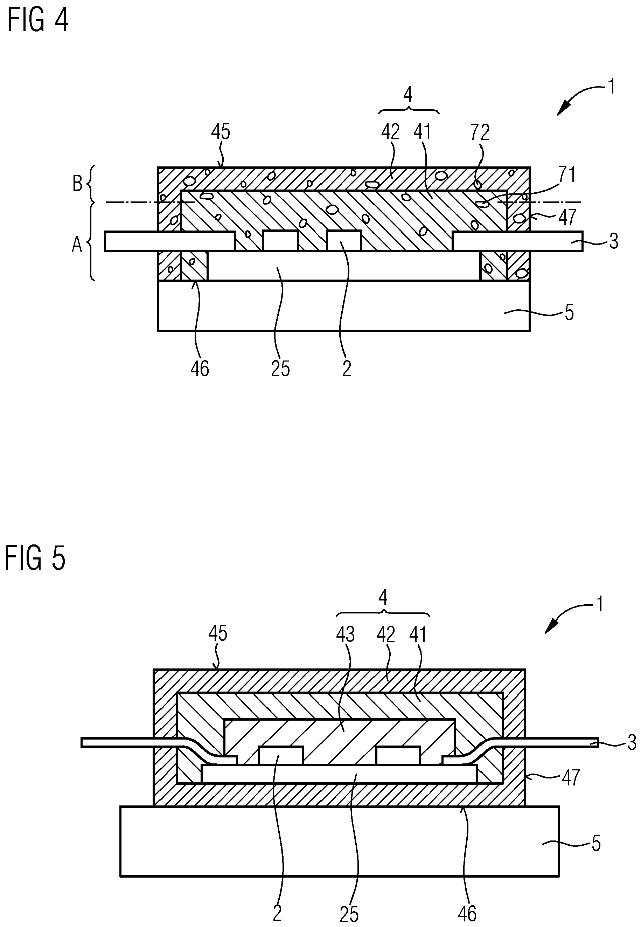

According to Figure 4, the semiconductor package 1 further comprises a circuit board 25. The circuit board 25 may be, for example, a direct bonded copper board or a metal core board or an insulated metal substrate with a resin isolating sheet. A plurality of the semiconductor chips 2 is mounted on the circuit board 25. Also the electric terminals 3 may be attached to the circuit board 25. As an option, there are the electric connection means 33 to electrically contact the semiconductor chips 2.

As a further option, semiconductor package 1 also comprises a heat sink 5. For example, the heat sink 5 is a metallic base plate or is a cooler in which a liquid coolant, not shown, may circulate. For example, the circuit board 25 is directly applied on the heat sink 5 to achieve an efficient thermal contact and efficient cooling.

Typically, for example, if the first body compound 41 and the second body compound 42 are mold compounds, they may comprise a filler material, like silicon oxide particles. Such a filler material, not shown in the drawings, may be present with a weight proportion of up to 90%.

Moreover, according to Figure 4 the second body compound 42 comprises a second filler 72, for example, particles of a metal oxide like aluminum oxide, or an additive dissolved in an organic material of the respective filler, in addition to the optional filler material. By means of the second filler 72, the CTI may be adjusted. Optionally, the first body compound 41 may contain a first filler 71, for example, in order to adjust a coefficient of thermal expansion, CTE for short, of the first body compound 41, also in addition to the optional filler material. It is possible that the second body compound 42 may also contain the first filler 71 used in the first body compound 41. The second filler 72 may be related to a different material or different chemical additives than the first filler 71. The same may apply to all other exemplary embodiments.

In Figure 4, the second body compound 42 is arranged with a constant thickness all around the first body compound 41 despite towards the heat sink 5. In other words, the second body compound 42 is present in a first region A close to the heat sink 5 and close to the electric terminals 3 at the lateral sides 47 as well as in a second region B at the top side 45. Accordingly, the first body compound 41 is encased by the second body compound 42 and the heat sink 5.

Otherwise, the second body compound 42 may only be present in the first region A. Hence, the lateral sides 47 may partially and the top side 45 may completely be free of the second body compound 42.

In such arrangements, the second body compound 42 is applied at least to areas at the surface of the package body 4 close to or in-between the electric terminals 3 and optionally auxiliary terminals, and in-between the heat sink 5 and the electric terminals 3, because these areas may be critical with respect to creepage behavior. Other than shown, lateral faces of the circuit board 25 may not be covered by the first body compound 41, but by the second body compound 42. The same may apply to all other exemplary embodiments.

Otherwise, the same as to Figures 1 to 3 may also apply to Figure 4, and vice versa.

In Figure 5, the electric terminals 3 are bent so that a distance between the electric terminals 3 and the optional heat sink 5 along the lateral sides 47 is increased, compared with the configuration of Figure 4. Such a geometry of the electric terminals 3 can also be present in all other exemplary embodiments.

Other than in Figure 4, the heat sink 5 may protrude from the package body 4 in a lateral direction, that is, in parallel with the top side 45.

Optionally, it is possible that the second body compound 42 is all around the first body compound 41. In this case, the second body compound 42 may have a comparably high thermal conductivity in order not to hamper cooling by means of the heat sink 5. In this case, the second body compound 42 next to the heat sink 5 could also work as an insulating layer between the circuit board 25 and the heat sink 5.

As an option, the package body 4 comprises a third body compound 43. For example, the third body compound 43 is arranged directly at the at least one semiconductor chip 2, and the first body compound 41 is applied on the third body compound 43.

According to at least one embodiment, the first body compound 41 and/or the second body compound 42 is of a hard material. This may mean that the body compound 41, 42 has a flexural modulus of at least 5 GPa or of at least 10 GPa and/or of at most 60 GPa or of at most 30 GPa. These values may apply at a temperature of 297 K, for example.

According to at least one embodiment, the third body compound 43 is of a soft material. This may mean that an elastic modulus of the third body compound 43 is at least 0.1 GPa or at least 1 GPa. Alternatively or additionally, said elastic modulus is at most 20 GPa or at most 10 GPa or at most GPa. These values may apply for a temperature of 297 K. By means of such a third body compound 43, stresses between at least one semiconductor chip 2 and the first and/or second body compound 41, 42 can be buffered.

Otherwise, the same as to Figures 1 to 4 may also apply to Figure 5, and vice versa.

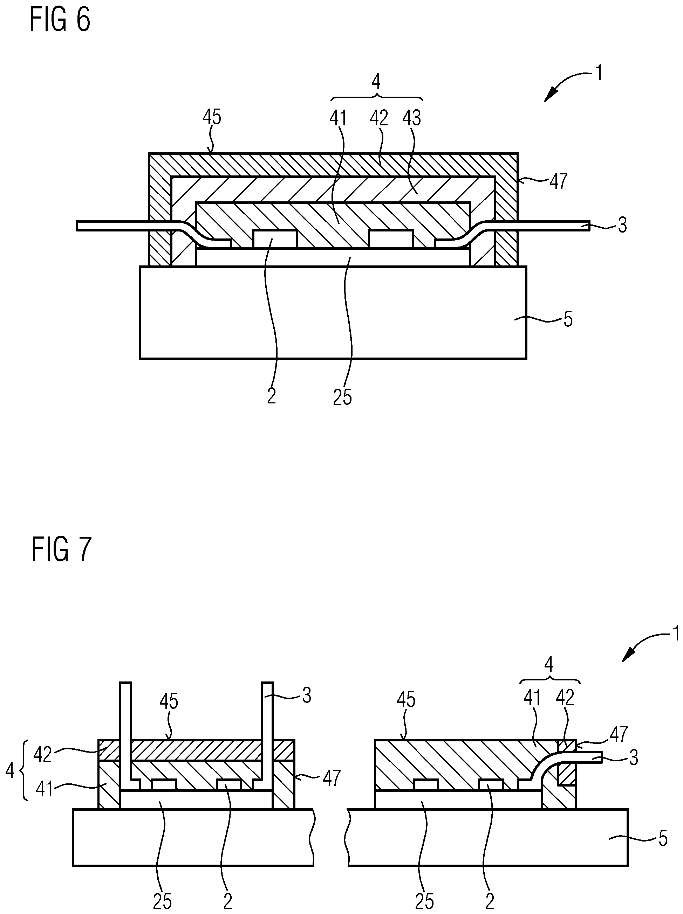

In Figure 6, there is also the third body compound 43 located between the first body compound 41 and the second body compound 42. The third body compound 43 may thus be in contact with the heat sink 5, with the electric terminals 3 and with the optional circuit board 25.

Otherwise, the same as to Figures 1 to 5 may also apply to Figure 6, and vice versa.

According to Figure 7, there are a plurality of the package bodies 4 on the common heat sink 5. The package bodies 4 may be configured as illustrated in Figure 1 to 6, for example, and all the package bodies 4 could be of the same type or different types of package bodies 4 may be combined with each other.

Moreover, Figure 7 illustrates further possibilities how to configure the package bodies 4. In Figure 7. left side, the electric terminals 3 leave the package body 4 on the top side 45, and the lateral sides 47 are free of the electric terminals 3. Thus, the second body compound 42 may essentially be limited to the top side 45 and may be a layer of constant thickness. The lateral sides 47 are only formed by the second body compound 42 with the thickness of the second body compound 42, said thickness amounts, for example, to at most 20% or to at most 10% of an overall thickness of the package body 4.

In the package bodies 4 on the right side of Figure 7, the electric terminals 3 leave the package bodies 4 on only one lateral side 47. Accordingly, the second body compound 42 may essentially be limited to the respective lateral side 47, and forms only a small proportion of the top side 45. Other areas of the respective lateral side 47 can be formed by the first body compound 41.

Otherwise, the same as to Figures 1 to 6 may also apply to Figure 7, and vice versa.

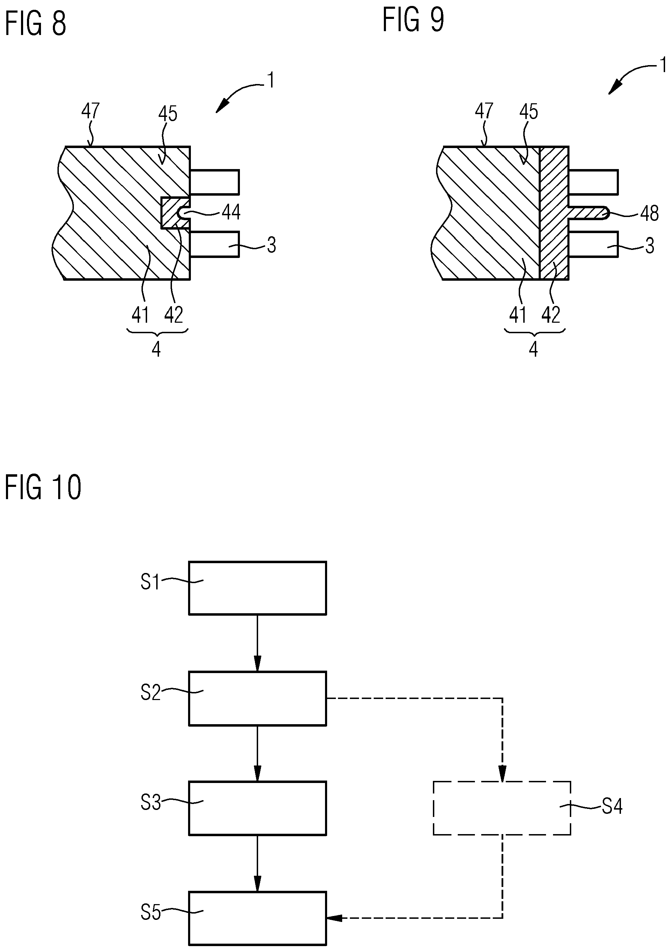

In Figures 8 and 9 it is illustrated that a critical creepage distance between adjacent electric terminals 3 is increased by a shape of the second body compound 42 between the respective electric terminals 3.

Thus, in Figure 8 the package body 4 comprises at least one notch 44 which is of the second body compound 42 and which is located between the at least two electric terminals 3, the at least one notch 44 increases the electric creep distance between the at least two electric terminals 3.

According to Figure 9, the package body 4 comprises at least one rib 48 which is of the second body compound 42 and which is located between the at least two electric terminals 3, the at least one rib 48 also increases an electric creep distance between the at least two electric terminals.

Such ribs 48 and/or notches 44 may alternatively or additionally be present between at least one of the electric terminals 3 and a further electrically conductive part of the semiconductor package 1, wherein the further electrically conductive part is, for example, the heat sink or one of the auxiliary terminals. Hence, the at least one rib 48 and/or the at least one notch 44 may be present, for example, between the electric terminals 3 and the optional heat sink and/or between the electric terminals 3 and the optional auxiliary terminals, not shown in Figures 8 and 9.

It is possible that the second body compound 42 is limited to the at least one notch 44 or rib 48 and its direct neighborhood, compare Figure 8, or that the complete respective lateral side 47 is formed by the second body compound 42 in at least one cross-section parallel to the top side 45.

Otherwise, the same as to Figures 1 to 7 may also apply to Figures 8 and 9, and vice versa.

In Figure 10, a method to produce the semiconductor package 1 is schematically illustrated. In a first method step S1, the at least one semiconductor chip 2 and the at least two electric terminals 3 are provided, wherein the at least one semiconductor chip 2 is electrically connected by means of the at least two electric terminals. In this method step, the circuit board and optionally also the heat sink may already be present.

In the method step S2, the first body compound 41 is molded, for example, around the at least one semiconductor chip 2 so that the at least two electric terminals 3 protrude from the first body compound 41 or are distant from the first body compound 41. The first body compound 41 is optionally in direct contact with the at least one semiconductor chip 2.

To improve adhesion with the subsequently applied second body compound 42, a surface treatment of the first body compound 41 may optionally performed.

Then, see method step S3, the second body compound 42 is applied directly or indirectly on the first body compound 41 at least at places where the at least two electric terminals 3 emerge from the finished package body 4 and/or at least at places which are critical concerning electric creepage behavior. The finished package body 4 thus comprises the first body compound 41 and the second body compound 42.

For example, method step S3 is a molding step. Hence, the package body 4 may be produced by means of multi-step molding.

As an alternative, see method step S4, the second body compound 42 is not produced by means of molding, but is produced from the previously applied first body compound 41 by means of a chemical reaction.

In an optional method step S5, the second body compound 42 is surface-treated after step C) to increase its CTI, or the surface of the second body compound 42 is subject to a chemical reaction. This surface treatment is, for example, a plasma treatment. Method step S5 could follow method step S3 as well as method step S4.

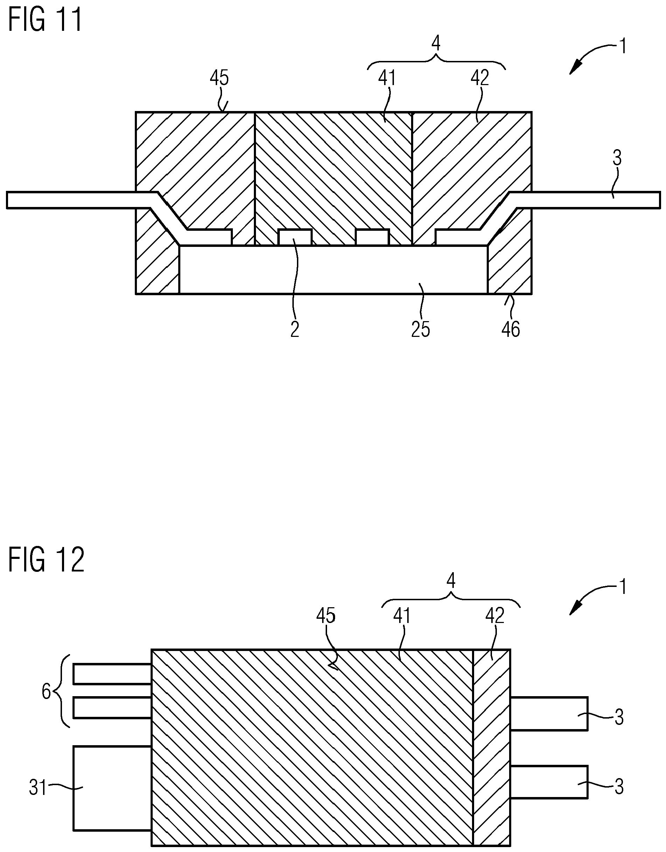

In Figure 11, it is illustrated that the electric terminals 3 may be distant from the first body compound 41 and may only be located in the second body compound 42. This may also apply to leadframe based semiconductor packages as illustrated, for example, in Figure 1. The bottom side 46 may consist of the second body compound 42 and the circuit board 25.

Otherwise, the same as to Figures 1 to 10 may also apply to Figure 11, and vice versa.

According to Figure 12, the second mold compound 42 is used near the electric terminals 3 only. Hence, the auxiliary terminals 6 may directly protrude from the first body compound 41, because the auxiliary terminals 6 are not configured to be applied with high voltages. As an option, there can be a further electric terminal 31, like a ground terminal. Because the further electric terminal 31 may not be an a high electric potential, there is no need for the second body compound 42 to be applied around the further electric terminal 31.

Otherwise, the same as to Figures 1 to 11 may also apply to Figure 12, and vice versa.

The components shown in the figures follow, unless indicated otherwise, preferably in the specified sequence directly one on top of the other. Components which are not in contact in the figures are preferably spaced apart from one another. If lines are drawn parallel to one another, the corresponding surfaces are preferably oriented in parallel with one another. Likewise, unless indicated otherwise, the positions of the drawn components relative to one another are correctly reproduced in the figures.

The semiconductor package and the method described herein are not restricted by the description on the basis of the exemplary embodiments. Rather, the semiconductor package and the method encompass any new feature and also any combination of features, which includes in particular any combination of features in the patent claims, even if this feature or this combination itself is not explicitly specified in the patent claims or exemplary embodiments.

### List of Reference Signs

- 1: semiconductor package
- 2: semiconductor chip
- 25: circuit board
- 3: electric terminal
- 31: further electric terminal
- 33: electric connection means
- 4: package body
- 41: first body compound
- 42: second body compound
- 43: third body compound
- 44: notch
- 45: top side of the package body
- 46: bottom side of the package body
- 47: lateral side of the package body
- 48: rib
- 5: heat sink
- 6: auxiliary terminal
- 71: first filler
- 72: second filler
- A: first region
- B: second region
- S..: method step
- T: thickness of the second body compound

## Claims

1. A semiconductor package (1) comprising:
- a package body (4),
- at least one semiconductor chip (2) arranged in the package body (4), and
- at least two electric terminals (3) by means of which the at least one semiconductor chip (2) is electrically connected, the at least two electric terminals (3) protrude from the package body (4),
wherein
- the package body (4) comprises a first body compound (41) and a second body compound (42), the first body compound (41) has a lower comparative tracking index, CTI, than the second body compound (42), and
- the CTI of the second body compound (42) is at least 100 larger than the CTI of the first body compound (41).

2. The semiconductor package (1) according to the preceding claim,
wherein the second body compound (42) forms at least places of a surface of the package body (4) where the at least two electric terminals (3) emerge from the package body (4), wherein the first body compound (41) as well as the second body compound (42) are mold compounds.

3. The semiconductor package (1) according to any one of the preceding claims,
wherein the second body compound (42) forms at least one lateral side (47) of the package body (40).

4. The semiconductor package (1) according to the preceding claim,
wherein the second body compound (42) forms all the lateral sides (47) of the package body (4) where electric terminals (3) emerge from the package body (4).

5. The semiconductor package (1) according to any one of the preceding claims,
wherein the second body compound (42) forms at least one of a top side (45) and a bottom side (46) of the package body (40) .

6. The semiconductor package (1) according to the preceding claim,
further comprising at least one heat sink (5) applied on the bottom side (46),
wherein the second body compound (42) is at least in places located between the heat sink (5) and the at least two electric terminals (3).

7. The semiconductor package (1) according to any one of the preceding claims,
wherein the second body compound (42) is all around the first body compound (41).

8. The semiconductor package (1) according to any one of the preceding claims,
wherein the package body (4) comprises at least one notch (44) or at least one rib (48) which is of the second body compound (42) and which is located at least one of between the at least two electric terminals (3) and between at least one of the two electric terminals (3) and a further electrically conductive part of the semiconductor package (1), the at least one notch (44) or the at least one rib (48) increases an electric creep distance between the at least two electric terminals (3) or between said at least one of the two electric terminals (3) and the further electrically conductive part.

9. The semiconductor package (1) according to any one of the preceding claims,
wherein a volume proportion of the second body compound (42) on the overall package body (4) is at least 2% and at most 25%.

10. The semiconductor package (1) according to any one of the preceding claims,
wherein a thickness (T) of the second body compound (42) is between 0.1 mm and 10 cm.

11. The semiconductor package (1) according to any one of the preceding claims,
wherein at least one of
- the second body compound (42) is a phenolic molding compound or an amino molding compound or an ethylene compound or a terephthalate compound and comprises at least one of a metal oxide filler, a bromine filler and an asbestos filler, and
- the first body compound (41) is an epoxy resin.

12. The semiconductor package (1) according to any one of the preceding claims,
wherein the package body (4) has dimensions of at least 3 cm x 3 cm x 0.2 cm and of at most 0.2 m x 0.2 m x 0.1 m.

13. The semiconductor package (1) according to any one of the preceding claims,
which is configured for voltages of at least 0.5 kV,
wherein the at least one semiconductor chip (2) is a power semiconductor chip.

14. A method for manufacturing a semiconductor package (1) according to any one of the preceding claims, comprising:
A) providing the at least one semiconductor chip (2) and the at least two electric terminals (3), the at least one semiconductor chip (2) is electrically connected by means of the at least two electric terminals (3),
B) molding the first body compound (41) around the at least one semiconductor chip (2) so that the at least two electric terminals (3) protrude from the first body compound (41) or are at least partly located outside the first body compound (41), and
C) applying the second body compound (42) on the first body compound (41) at least at places where the at least two electric terminals (3) emerge from the finished package body (4) .

15. The method according to the preceding claim,
wherein surface-treating the second body compound (42) after step C) to increase its CTI.
